# EUROPEAN PATENT APPLICATION

(11) **EP 4 750 265 A1**
(43) Date of publication of application: **27.05.2026**
(21) Application number: 25171438.2
(22) Date of filing: 17.04.2025
(51) Int. Cl.: H10F 10/165, H10F 10/166, H10F 77/20

(54) **SOLAR CELL, PREPARATION METHOD THEREOF, AND PHOTOVOLTAIC MODULE**

(30) Priority: 26.11.2024 CN 202411708348
(71) Applicant: Jinko Solar (Shangrao) Co., Ltd, Jiangxi 334100 (CN); Zhejiang Jinko Solar Co., Ltd., Haining, Zhejiang 314416 (CN)
(72) Inventor: DUAN, Weiyuan, SHANGRAO, 334100 (CN); LI, Wenqi, SHANGRAO, 334100 (CN); YANG, Jie, SHANGRAO, 334100 (CN); ZHANG, Xinyu, SHANGRAO, 334100 (CN)
(74) Representative: Haseltine Lake Kempner LLP

(57) **Abstract**

A solar cell includes a substrate having a front surface and a back surface disposed opposite to each other; the back surface of the substrate includes a first doped region and a second doped region, and an insulating region; a doped polysilicon passivation contact structure disposed in the first doped region, a doped amorphous silicon structure disposed in the second doped region, and a passivation layer disposed in the insulating region; the doped polysilicon passivation contact structure including a tunneling oxide layer and a doped polysilicon layer; the doped amorphous silicon structure including a doped amorphous silicon layer, and the doped polysilicon layer and the doped amorphous silicon layer having different doping types; wherein the passivation layer is not overlapped with the doped polysilicon passivation contact structure or the doped amorphous silicon structure along a thickness direction of the substrate.

## Description

### TECHNICAL FIELD

Embodiments of the present disclosure relate to the field of photovoltaic technology, in particular to a solar cell, a method for preparing the same, and a photovoltaic module.

### BACKGROUND

Photovoltaic power generation involves converting solar energy into electrical energy through photovoltaic modules, which provides a green, environmentally friendly, and renewable energy production method, thereby have been widely used in many fields. Photovoltaic module includes cell strings, which are formed by connecting multiple solar cells.

Back-contact solar cells are an important type of cells. A back surface of a back-contact solar cell has N-type doped regions and P-type doped regions alternately arranged, but adjacent N-type doped region and P-type doped region are prone to generate electric leakage, thereby reducing the photoelectric conversion efficiency.

### SUMMARY

Embodiments of the present disclosure provide a solar cell, a method for preparing the same, and a photovoltaic module, which avoid electric leakage between doping regions with different doping types, thereby improving photoelectric conversion efficiency.

According to some embodiments of the present disclosure, one aspect of the embodiments provides a solar cell, including a substrate having a front surface and a back surface disposed opposite to each other; the back surface of the substrate includes a first doped region and a second doped region that are spaced apart, and an insulating region disposed between the first doped region and the second doped region;
the solar cell further including: a doped polysilicon passivation contact structure disposed in the first doped region, a doped amorphous silicon structure disposed in the second doped region, and a passivation layer disposed in the insulating region. The doped polysilicon passivation contact structure including a tunneling oxide layer and a doped polysilicon layer that are stacked on the back surface of the substrate sequentially; the doped amorphous silicon structure includes a doped amorphous silicon layer, and the doped polysilicon layer and the doped amorphous silicon layer have different doping types;
wherein the passivation layer is not overlapped with the doped polysilicon passivation contact structure or the doped amorphous silicon structure along a thickness direction of the substrate.

According to some embodiments of the present disclosure, a surface of the tunneling oxide layer adjacent to the substrate is lower than each of a surface of the doped amorphous silicon structure adjacent to the substrate and a surface of the passivation layer adjacent to the substrate along a preset direction, and the preset direction is a direction from the front surface of the substrate to the back surface of the substrate.

According to some embodiments of the present disclosure, the surface of the doped amorphous silicon layer adjacent to the substrate is flush with the surface of the passivation layer adjacent to the substrate.

According to some embodiments of the present disclosure, the surface of the passivation layer adjacent to the substrate is higher than the surface of the doped amorphous silicon structure adjacent to the substrate along the preset direction;

or the surface of the passivation layer adjacent to the substrate is lower than the surface of the doped amorphous silicon structure adjacent to the substrate along the preset direction.

According to some embodiments of the present disclosure, a surface of the tunneling oxide layer adjacent to the substrate, a surface of the doped amorphous silicon structure adjacent to the substrate, and a surface of the passivation layer adjacent to the substrate are flush with each other.

According to some embodiments of the present disclosure, in the substrate, a surface of the substrate in contact with the tunneling oxide layer, a surface of the substrate in contact with the doped amorphous silicon structure, and a surface of the substrate in contact with the passivation layer are all polished surfaces or textured surfaces.

According to some embodiments of the present disclosure, in the substrate, a surface of the substrate in contact with the tunneling oxide layer is a polished surface, and both of a surface of the substrate in contact with the doped amorphous silicon structure and a surface of the substrate in contact with the passivation layer are textured surfaces.

According to some embodiments of the present disclosure, a width of the insulating region along an arrangement direction of the first doped region and the second doped region ranges from 150 µm to 300 µm.

According to some embodiments of the present disclosure, the doped polysilicon passivation contact structure further includes: a first transparent conducting layer disposed on a side of the doped polysilicon layer away from the substrate;
the doped amorphous silicon structure further includes an intrinsic hydrogenated amorphous silicon layer and a second transparent conducting layer disposed in the second doped region, the intrinsic hydrogenated amorphous silicon layer is disposed on a side of the doped amorphous silicon layer adjacent to the substrate, and the second transparent conducting layer is disposed on a side of the doped amorphous silicon layer away from the substrate;
the solar cell further includes an anti-reflection layer disposed in the insulating region, the anti-reflection layer is disposed on a side of the passivation layer away from the substrate; wherein the passivation layer and the anti-reflection layer both are not overlapped with the first transparent conducting layer or the second transparent conducting layer along a thickness direction of the substrate.

According to some embodiments of the present disclosure, a ratio of an overall thickness of the passivation layer and the anti-reflection layer to an overall thickness of the tunneling oxide layer, the doped polysilicon layer, and the first transparent conducting layer ranges from 1:1.3 to 1:2;
a ratio of an overall thickness of the passivation layer and the anti-reflection layer to an overall thickness of the intrinsic hydrogenated amorphous silicon layer, the doped amorphous silicon layer, and the second transparent conducting layer ranges from 1: 1.2 to 1:2.

According to some embodiments of the present disclosure, another aspect of the embodiments provides a method for preparing a solar cell, including:
providing a substrate having a front surface and a back surface disposed opposite to each other; the back surface of the substrate includes a first doped region and a second doped region that are spaced apart, and an insulating region disposed between the first doped region and the second doped region;
forming a doped polysilicon passivation contact structure, a doped amorphous silicon structure, and a passivation layer on the back surface of the substrate; wherein the doped polysilicon passivation contact structure is disposed in the first doped region, and the doped polysilicon passivation contact structure includes: a tunneling oxide layer and a doped polysilicon layer that are stacked on the back surface of the substrate sequentially; the doped amorphous silicon structure is disposed in the second doped region, the doped amorphous silicon structure includes a doped amorphous silicon layer, and the doped polysilicon layer and the doped amorphous silicon layer have different doping types; and the passivation layer is disposed in the insulating region, and the passivation layer is not overlapped with the doped polysilicon passivation contact structure or the doped amorphous silicon structure along a thickness direction of the substrate.

According to some embodiments of the present disclosure, forming the doped polysilicon passivation contact structure, the doped amorphous silicon structure, and the passivation layer on the back surface of the substrate includes:
forming the doped polysilicon passivation contact structure, the passivation layer, and the doped amorphous silicon structure on the back surface of the substrate sequentially.

According to some embodiments of the present disclosure, a still another aspect of the embodiments provides a photovoltaic module including:
a cell string formed by connecting a plurality of solar cells described in any of the above embodiments, or formed by connecting a plurality of solar cells formed by the method for preparing the solar cell described above;
an encapsulating adhesive film configured to cover a surface of the cell string; and
a cover plate configured to cover a surface of the encapsulating adhesive film away from the cell string.

Embodiments of the present disclosure provide a solar cell, a method for preparing the same, and a photovoltaic module. According to the solar cell provided in the embodiments of the present disclosure, the insulating region is disposed between the first doped region and the second doped region, and the doped polysilicon passivation contact structure in the first doped region and the doped amorphous silicon structure in the second doped region are completely isolated from each other by the passivation layer in the insulating region, so that there is no need to reduce the doping concentrations of the doped polysilicon layer and the doped amorphous silicon layer. That is, electric leakage between the doped polysilicon passivation contact structure and the doped amorphous silicon structure can be avoided without reducing the performance of the cell, thereby improving the photoelectric conversion efficiency.

### BRIEF DESCRIPTION OF THE DRAWINGS

FIG. 1 is a schematic structural view of a solar cell provided in an embodiment of the present disclosure.
FIGS. 2 and 3 are two schematic cross-sectional views of FIG. 1 along a cross-sectional direction CD.
FIGS. 4 to 7 show multiple schematic structural views in a process of preparing a solar cell shown in FIG. 3.
FIGS. 8 to 12 are various schematic cross-sectional views along the cross-sectional direction CD of FIG. 1.
FIG. 13 is a bottom view of FIG. 2.
FIG. 14 is a perspective view of a photovoltaic module provided in an embodiment of the present disclosure.
FIG. 15 is a schematic cross-sectional view of FIG. 14 along a cross-sectional direction NN1.

### DETAILED DESCRIPTION

The technical solutions of the present disclosure will now be clearly described in detail with reference to the specific embodiments and the corresponding drawings of the present disclosure in order to make the objectives, technical solutions, and advantages of the present disclosure clearer. Apparently, the described embodiments are only a part of the embodiments of the present disclosure rather than all the embodiments. All other embodiments obtained by those of ordinary skill in the art based on the embodiments in the present disclosure without any creative effort are within the scope of protection of the present disclosure.

In the description of the embodiments of the present disclosure, "at least one" means one or more, "at least one layer" means one or more layers, "a plurality of " means two or more, "a plurality of layers" means two or more layers, "a plurality of groups" means two or more groups, and "a plurality of sheets" means two or more sheets, unless otherwise clearly defined.

In the description of the embodiments of the present disclosure, the technical terms "first", "second", etc. are only used to distinguish different objects and cannot be understood as indicating or implying relative importance or implicitly indicating the quantity, particular order, or primary and secondary relationship of the indicated technical features.

In the description of the embodiments of the present disclosure, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present disclosure and simplifying the description, rather than indicating or implying that the related devices or element must have the specific orientations, or be constructed or operated in the specific orientations, and therefore cannot be understood as limitations of the present disclosure. For example, if a device or an element in a diagram is inverted, elements described as "below", "beneath", "under", or "bottom of" other elements or features would be oriented "above" or "on top of" these other elements or features. Thus, the term "below" can encompass both orientations of "above" and "below" depending on the context in which the term is used, which is apparent to ordinary skilled in the art. Materials can be otherwise oriented, e.g., rotated 90 degrees, inverted, flipped. The spatially relative descriptors used herein can be interpreted accordingly.

In the description of the embodiments of the present disclosure, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element, or connected to the other element via an intermediate medium, or may be internal communication between two elements or interaction between two elements. For those skilled in the art, the specific meanings of the above terms in the embodiments of the present disclosure can be understood according to specific circumstances.

In the accompanying drawings corresponding to the embodiments of the present disclosure, the thickness and area of layers are exaggerated for better understanding and describing. In addition, when a component is described to be "substantially" formed on another component, it means that the component is not formed on the entire surface or front surface of this another component, nor is it formed on a partial edge of the entire surface.

In the description of the embodiments of the present disclosure, unless otherwise specified, when a specific component "includes" another component, other components are not excluded and may be further included. When a second component is formed or disposed above or on a first component, or a second component is formed or disposed on a surface of a first component, or a second component is formed or disposed on a side of a first component, these may include both embodiments in which the first component and the second component are in a direct contact, and embodiments in which additional components are arranged between the first component and the second component, so that the first component and the second component may not be in a direct contact. For the sake of simplicity and clarity, various components can be arbitrarily drawn in different proportions. In the drawings, some layers or components can be omitted for simplicity. Unless otherwise specified, when a second component is formed or disposed on a surface of a first component, it means that the first component is in a direct contact with the second component. Among them, the above-mentioned "component" can be a layer, a film, a region, a section, a structure, etc.

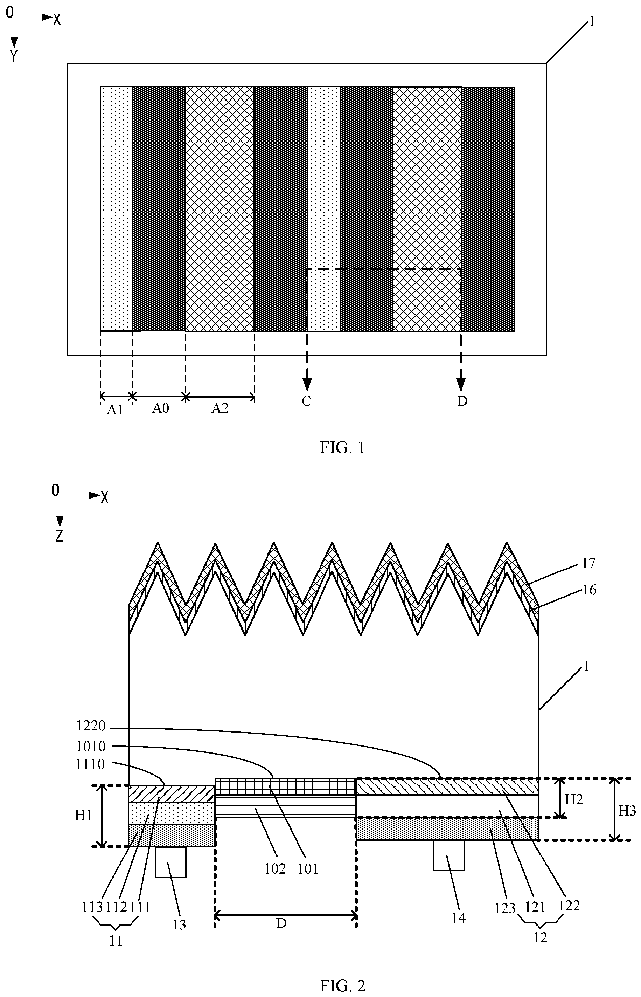

An embodiment of the present disclosure provides a solar cell including a substrate, the substrate includes a front surface and a back surface disposed opposite to each other. As shown in FIG. 1, the back surface of the substrate 1 includes a first doped region A1 and a second doped region A2 that are spaced apart from each other, and an insulating region A0 disposed between the first doped region A1 and the second doped region A2.

Referring to FIGS. 2, 3 and 8 to 12, the solar cell further includes: a doped polysilicon passivation contact structure 11 disposed in the first doped region, a doped amorphous silicon structure 12 disposed in the second doped region, and a passivation layer 101 disposed in the insulating region. The doped polysilicon passivation contact structure 11 includes a tunneling oxide layer 111 and a doped polysilicon layer 112 that are stacked sequentially on the back surface of the substrate 1. The doped amorphous silicon structure 12 includes a doped amorphous silicon layer 121. The doped polysilicon layer 112 and the doped amorphous silicon layer 121 have different doping types. The passivation layer 101 is not overlapped with the doped polysilicon passivation contact structure 11 or the doped amorphous silicon structure 12 along a thickness direction of the substrate.

According to the doped polysilicon passivation contact structure in the embodiment of the present disclosure, the doping element concentration of the doped polysilicon layer can be greater than the doping element concentration of the substrate, so that a sufficiently high potential barrier can be formed on the back surface of the substrate, which can induce bending of the energy band of the back surface of the substrate, realizing the aggregation of majority carriers and the depletion of minority carriers at the back surface of the substrate, thereby reducing the recombination of the carriers at the back surface of the substrate. The tunneling oxide layer can cause an asymmetric shift of the energy band of the back surface of the substrate, so that the potential barrier to the majority carriers among the carriers is lower than the potential barrier to the minority carriers among the carriers. Therefore, the majority carriers can easily perform quantum tunneling through the tunneling oxide layer to be transmitted to the doped polysilicon layer, while the minority carriers are difficult to extend through the tunneling oxide layer, thereby realizing the selective transmission of carriers.

In addition, the tunneling oxide layer further has a chemical passivation effect. Specifically, due to the presence of interface state defects at the interface between the substrate and the tunneling oxide layer, the interface state density on the back surface of the substrate is relatively large, and the increased interface state density will promote the recombination of photogenerated carriers, thereby reducing the fill factor, short-circuit current, and open-circuit voltage of the solar cell, and thus lowering the photoelectric conversion efficiency of the solar cell. The tunneling oxide layer plays a chemical passivation role by saturating the dangling bonds on the back surface of the substrate, thereby reducing the defect state density on the back surface of the substrate, and in turn reducing the recombination centers on the substrate surface to reduce the recombination rate of carriers.

In embodiments of the present disclosure, a material of the tunneling oxide layer can be at least one of silicon oxide, silicon nitride, silicon oxynitride, silicon carbide, or magnesium fluoride.

In embodiments of the present disclosure, the doped polysilicon layer can also have a field passivation effect. Specifically, the doped polysilicon layer forms an electrostatic field pointing to the inside of the substrate on the back surface of the substrate to cause the minority carriers to escape from the interface, thereby reducing the concentration of the minority carriers and reducing the recombination rate of carriers at the interface of the substrate, and thereby increasing the open circuit voltage, short circuit current, and fill factor of the solar cell, and improving the photoelectric conversion efficiency of the solar cell.

The doped polysilicon layer can be doped with doping elements having the same type as those of the substrate. For example, if the doping elements of the substrate are P-type, the doping elements of the doped polysilicon layer can also be P-type, and in this case, the doping elements of the doped amorphous silicon layer can be N-type. That is, the first doped region is a P-type doped region, and the second doped region is an N-type doped region. If the doping elements of the substrate are N-type, the doping elements of the doped polysilicon layer can also be N-type, and in this case, the doping elements of the doped amorphous silicon layer can be P-type. That is, the first doped region is an N-type doped region, and the second doped region is a P-type doped region.

In embodiments of the present disclosure, the doped polysilicon passivation contact structure provides good surface passivation for the back surface of the substrate. The tunneling oxide layer allows the majority carriers to tunnel into the doped polysilicon layer while blocking the recombination with the minority carriers, so that the majority carriers are transmitted laterally in the doped polysilicon layer and collected by the metal electrode, thereby greatly reducing the metal contact recombination current and improving the open circuit voltage and short circuit current of the solar cell.

In embodiments of the present disclosure, the structure of the doped amorphous silicon layer is not limited. For example, the doped amorphous silicon layer can be any one or a stack body of any multiple layers selected from a group consisting of a doped hydrogenated amorphous silicon layer (a-Si:H), a hydrogenated nanocrystalline silicon layer (nc-Si:H), and a hydrogenated nanocrystalline silicon oxide layer (nc-SiOx:H). The type of doping elements of the doped amorphous silicon layer is not limited. Taking P-type amorphous silicon layer as an example for explanation, the P-type doped amorphous silicon layer can be a P-type hydrogenated amorphous silicon layer (a-Si:H (p)), a P-type hydrogenated nanocrystalline silicon layer (nc-Si:H (p)), or a P-type hydrogenated nanocrystalline silicon oxide layer (nc-SiOx:H(p)). Alternatively, the P-type doped amorphous silicon layer can be a stacked structure of a P-type hydrogenated amorphous silicon layer, a P-type hydrogenated nanocrystalline silicon layer, and a P-type hydrogenated nanocrystalline silicon oxide layer stacked sequentially on the back surface of the substrate. In this stacked structure, the thickness ratio of the P-type hydrogenated amorphous silicon layer, the P-type hydrogenated nanocrystalline silicon layer, and the P-type hydrogenated nanocrystalline silicon oxide layer ranges from 1:3:1 to 1:10:1. Specifically, the thickness ratio of the P-type hydrogenated amorphous silicon layer, the P-type hydrogenated nanocrystalline silicon layer, and the P-type hydrogenated nanocrystalline silicon oxide layer can be 1:3:1, 1:4:1, 1:5:1, 1:6:1, 1:7:1, 1:8:1, 1:9:1, or 1:10:1.

In embodiments of the present disclosure, a material of the passivation layer is not limited. For example, a material of the passivation layer can be silicon oxide, aluminum oxide, silicon nitride, silicon carbide, or silicon oxynitride. On one hand, silicon oxide, aluminum oxide, silicon nitride, or silicon oxynitride has a good insulation property and can play a good insulation effect to ensure the doped polysilicon passivation contact structure to be insulated from the doped amorphous silicon layer. On the other hand, silicon oxide, aluminum oxide, silicon nitride, and silicon oxynitride are all high-transmittance materials with a transmittance greater than 80%, which can greatly improve the bifacial factor of solar cells.

In embodiments of the present disclosure, the doped polysilicon layer can be an N-type polysilicon layer, and the doped amorphous silicon layer can be a P-type amorphous silicon layer. Alternatively, the doped polysilicon layer can be a P-type polysilicon layer, and the doped amorphous silicon layer can be an N-type amorphous silicon layer. For example, the N-type polysilicon layer can be obtained by doping phosphorus in polysilicon, and the doping concentration of phosphorus can range from 1E19/cm^3 to 6E20/cm^3. Specifically, the doping concentration of phosphorus can be 1E19/cm^3, 1E20/cm^3, 2E20/cm^3, 3E20/cm^3, 4E20/cm^3, 5E20/cm^3, or 6E20/cm^3.

In embodiments of the present disclosure, the solar cell can be a single-sided cell, in which the front surface of the substrate can be used as a light-receiving surface for receiving incident light, and the back surface can be used as a backlight surface. Alternatively, the solar cell can be a double-sided cell, in which both the front surface and the back surface of the substrate can be used as light-receiving surfaces for receiving incident light, the front surface can be the main light-receiving surface, and the back surface can be the secondary light-receiving surface. It can be understood that the backlight surface referred to in the embodiments of the present disclosure can also receive incident light, with the degree of receiving incident light weaker than that of the light-receiving surface, and therefore is defined as a backlight surface.

In embodiments of the present disclosure, at least one of the front and back surfaces of the substrate can be subjected to a texturing process, so that a textured surface is formed on at least one of the front and back surfaces of the substrate, which can enhance the absorption utilization rate of the front and back surfaces of the substrate for incident light. In some embodiments, the textured surface can be a pyramid textured surface, which not only reduces the reflectivity of the substrate surface, but also forms a light trap, thereby enhancing the absorption effect of the substrate on incident light, and improving the photoelectric conversion efficiency of the solar cell.

For example, if the solar cell is a single-sided cell, a textured surface such as a pyramid textured surface can be formed on the light-receiving surface of the substrate, and the backlight surface of the substrate can be a polished surface, so that the backlight surface of the substrate is flatter than the light-receiving surface. It should be noted that for single-sided cells, textured surfaces can also be formed on both the light-receiving surface and the backlight surface of the substrate. If the solar cell is a double-sided cell, textured surfaces can be formed on both the light-receiving surface and the backlight surface of the substrate.

In embodiments of the present disclosure, the substrate is configured to receive incident light and generate photogenerated carriers. The type of the substrate is not limited. For example, the substrate can be an N-type semiconductor substrate, or a P-type semiconductor substrate. The N-type semiconductor substrate is doped with an N-type doping element, and the N-type doping element can be any one of the V-group elements, such as phosphorus (P), bismuth (Bi), antimony (Sb), or arsenic (As). The P-type semiconductor substrate is doped with a P-type element, and the P-type doping element can be any one of the III-group elements, such as boron (B), aluminum (Al), gallium (Ga), or indium (In).

In embodiments of the present disclosure, a material of the substrate is not limited. For example, the material of the substrate can be an elemental semiconductor material. The elemental semiconductor material can be composed of a single element, for example, silicon, or germanium. The morphology of the elemental semiconductor material can be single crystal, polycrystalline, amorphous, or microcrystalline (in which a state having both single crystal and amorphous states is called microcrystalline). For example, silicon can be at least one selected from single crystal silicon, polycrystalline silicon, amorphous silicon, and microcrystalline silicon. Alternatively, the material of the substrate can be a compound semiconductor material, for example, silicon germanium, silicon carbide, gallium arsenide, indium gallium, perovskite, cadmium telluride, copper indium selenide, etc.

In embodiments of the present disclosure, the substrate can be a sapphire substrate, a silicon on insulator substrate, or a germanium on insulator substrate.

In embodiments of the present disclosure, the doped polysilicon passivation contact structure is disposed in the first doped region, the doped amorphous silicon layer is disposed in the second doped region, and the solar cell provided in the embodiments of the present disclosure is a hybrid back contact cell in combination of Tunnel Oxide Passivated Contact (TOPCon) cell technology with Heterojunction Technology (HIT/HJT) cell technology.

The size of the solar cell is not limited. For example, the solar cell can be a complete cell sheet, a half of a cell sheet, or a quarter of a cell sheet.

In the related art, electric leakage is solved by reducing the doping concentrations of the first doped region and the second doped region. In contrast, according to the solar cell provided in the embodiments of the present disclosure, the insulating region is disposed between the first doped region and the second doped region, and the doped polysilicon passivation contact structure in the first doped region and the doped amorphous silicon structure in the second doped region are completely isolated from each other by the passivation layer in the insulating region, so that there is no need to reduce the doping concentrations of the doped polysilicon layer and the doped amorphous silicon layer. That is, electric leakage between the doped polysilicon passivation contact structure and the doped amorphous silicon structure can be avoided without reducing the performance of the cell, thereby improving the photoelectric conversion efficiency.

A group of test data is provided below to illustrate various performances of the solar cell provided in an example of the present disclosure.

Example of the present disclosure refers to the solar cell including the insulating region as shown in FIG. 1. Comparative example refers to a solar cell not including the insulating region. The rest of the structures of both are the same. Various test data is shown in Table 1.

**Table 1**

| | Voc | Isc | FF | Eta |
|---|---|---|---|---|
| Comparative Example | 735 mV | 42.38 mA/cm² | 83.89% | 26.14% |
| Example of the present disclosure | 735 mV | 42.32 mA/cm² | 84.63% | 26.33% |

It can be directly concluded from Table 1 that the performances on open circuit voltage (Voc) and short circuit current (Isc) are not apparently different between the present example and the comparative example, but the fill factor (FF) of the present example is significantly greater than the fill factor (FF) of the comparative example, indicating that the contact electrical performance of the present example is better. Therefore, the conversion efficiency (Eta) of the present example is greater than the conversion efficiency (Eta) of the comparative example.

In embodiments of the present disclosure, a ratio of an area of the insulating region to an area of the back surface of the cell is not limited and can be defined according to actual conditions. For example, a percentage of the ratio of area of the insulating region to area of the back surface of the cell can range from 10% to 50%. For example, the percentage of the ratio of area of the insulating region to area of the back surface of the cell is 10%, 15%, 20%, 25%, 30%, 35%, 40%, 45%, or 50%.

In embodiments of the present disclosure, a ratio of an area of the first doped region to an area of the back surface of the cell is not limited and can be defined according to actual conditions. For example, a percentage of the ratio of area of the first doped region to area of the back surface of the cell can range from 10% to 30%. For example, the percentage of the ratio of area of the first doped region to area of the back surface of the cell is 10%, 13%, 15%, 18%, 20%, 23%, 25%, 28%, or 30%.

In embodiments of the present disclosure, a ratio of an area of the second doped region to an area of the back surface of the cell is not limited and can be defined according to actual conditions. For example, a percentage of the ratio of area of the second doped region to area of the back surface of the cell can range from 20% to 40%. For example, the percentage of the ratio of area of the second doped region to area of the back surface of the cell is 20%, 23%, 25%, 28%, 30%, 33%, 35%, 38%, or 40%.

In embodiments of the present disclosure, heights of a surface of the tunneling oxide layer adjacent to the substrate, a surface of the doped amorphous silicon structure adjacent to the substrate, and a surface of the passivation layer adjacent to the substrate along a preset direction are not limited, where the preset direction is a direction from the front surface of the substrate to the back surface of the substrate.

It should be noted that the doped amorphous silicon structure can include a plurality of film layers, and a surface of the doped amorphous silicon structure adjacent to the substrate refers to a surface of a film layer in the doped amorphous silicon structure in contact with the substrate which is adjacent to the substrate. For example, if the doped amorphous silicon structure includes a doped amorphous silicon layer, and the doped amorphous silicon layer is in contact with the substrate, then a surface of the doped amorphous silicon structure adjacent to the substrate refers to a surface of the doped amorphous silicon layer adj acent to the substrate. Referring to FIGS. 2, 3 and 8 to 12, the doped amorphous silicon structure 12 includes an intrinsic hydrogenated amorphous silicon layer 122 and a doped amorphous silicon layer 121 that are stacked, and the intrinsic hydrogenated amorphous silicon layer 122 is disposed on a side of the doped amorphous silicon layer 121 adjacent to the substrate 1. In this case, the intrinsic hydrogenated amorphous silicon layer 122 is in contact with the substrate 1, and the surface of the doped amorphous silicon structure 12 adjacent to the substrate 1 refers to the surface of the intrinsic hydrogenated amorphous silicon layer 122 adjacent to the substrate 1. FIGS. 2, 3 and 8 to 12 are all illustrated by taking the example that the surface of the doped amorphous silicon structure adj acent to the substrate is the surface of the intrinsic hydrogenated amorphous silicon layer adjacent to the substrate.

Specifically, referring to FIGS. 2, 3 and 8 to 10, a surface 1110 of the tunneling oxide layer 111 adjacent to the substrate 1 is lower than each of a surface 1220 of the doped amorphous silicon structure 12 adjacent to the substrate 1 and a surface 1010 of the passivation layer 101 adjacent to the substrate 1 along a preset direction OZ, and the preset direction OZ is a direction from the front surface of the substrate 1 to the back surface of the substrate 1.

In some embodiments, in order to facilitate manufacturing and reduce the difficulty of manufacturing, referring to FIGS. 2, 3 and 8, the surface 1220 of the doped amorphous silicon structure 12 adjacent to the substrate 1 is flush with the surface 1010 of the passivation layer 101 adjacent to the substrate 1. In this case, a surface of the substrate in contact with the doped amorphous silicon structure and a surface of the substrate in contact with the passivation layer can both be polished surfaces or textured surfaces.

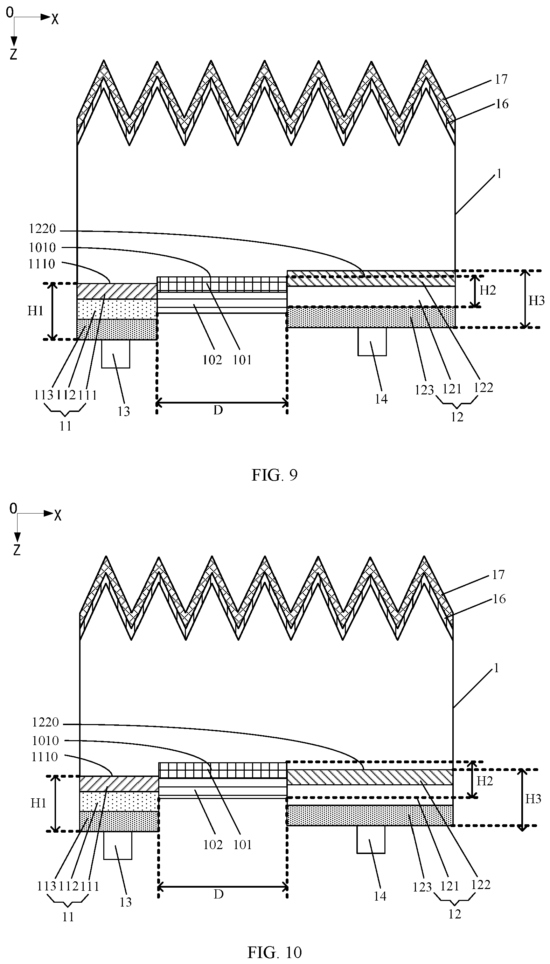

In some embodiments, as shown in FIG. 10, the surface 1010 of the passivation layer 101 adjacent to the substrate 1 is higher than the surface 1220 of the doped amorphous silicon structure 12 adjacent to the substrate 1 along the preset direction OZ. Alternatively, as shown in FIG. 9, the surface of the passivation layer 101 adjacent to the substrate 1 is lower than the surface of the doped amorphous silicon structure 12 adjacent to the substrate 1 along the preset direction OZ.

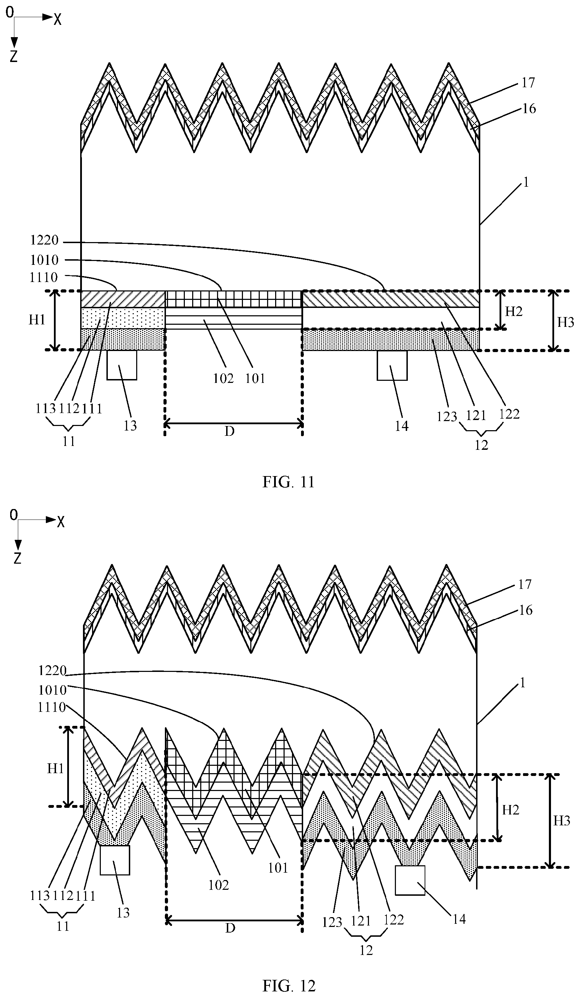

Specifically, in order to facilitate manufacturing and reduce the difficulty of manufacturing, referring to FIGS. 11 and 12, the surface 1110 of the tunneling oxide layer 111 adjacent to the substrate 1, the surface 1220 of the doped amorphous silicon structure 12 adjacent to the substrate 1, and the surface 1010 of the passivation layer 101 adjacent to the substrate 1 are flush with each other.

According to the substrate of the solar cell in the present embodiments, types of the surface of the substrate in contact with the tunneling oxide layer, the surface of the substrate in contact with the doped amorphous silicon structure, and the surface of the substrate in contact with the passivation layer are not limited.

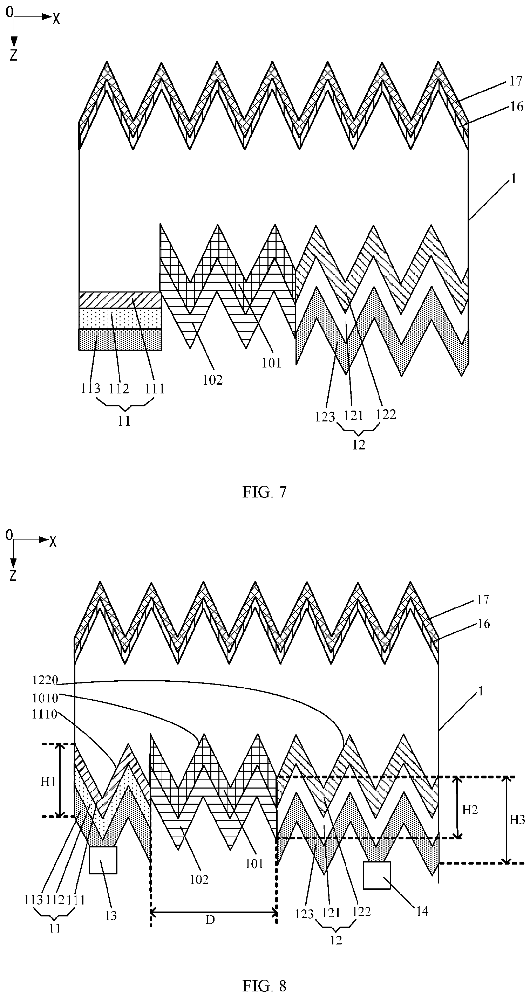

Specifically, in one or more embodiments, in order to facilitate manufacturing and reduce the difficulty of manufacturing, in the substrate, the surface of the substrate 1 in contact with the tunneling oxide layer 111, the surface of the substrate 1 in contact with the doped amorphous silicon structure 12, and the surface of the substrate in contact with the passivation layer 101 are all polished surfaces as shown in FIGS. 10 and 11, or textured surfaces as shown in FIG. 8.

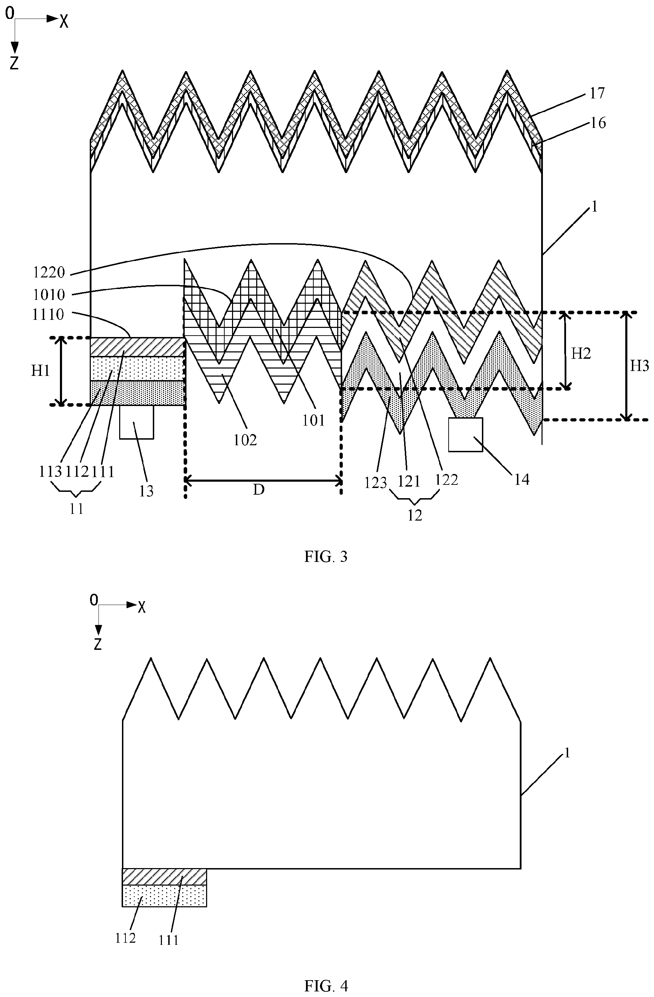

Alternatively, in one or more embodiments, taking the actual process conditions into account, referring to FIG. 3, in the substrate 1, the surface of the substrate 1 in contact with the tunneling oxide layer 111 is a polished surface, and both the surface of the substrate 1 in contact with the doped amorphous silicon structure 12 and the surface of the substrate 1 in contact with the passivation layer 101 are textured surfaces.

Of course, when the surface of the substrate in contact with the tunneling oxide layer is a polished surface, either the surface of the substrate in contact with the doped amorphous silicon structure or the surface of the substrate in contact with the passivation layer is a polished surface and the other of them is a textured surface. Specifically, the surface of the substrate in contact with the doped amorphous silicon structure is a polished surface, and the surface of the substrate in contact with the passivation layer is a textured surface. Alternatively, the surface of the substrate in contact with the doped amorphous silicon structure is a textured surface, and the surface of the substrate in contact with the passivation layer is a polished surface.

In one or more embodiments, in order to achieve a good insulation effect and minimize the area occupied on the back surface of the cell, the width of the insulating region along an arrangement direction of the first doped region and the second doped region ranges from 150 µm to 300 µm. For example, referring to FIG. 2, the width D of the insulating region along the arrangement direction of the first doped region and the second doped region is 150 µm, 170 µm, 200 µm, 230 µm, 250 µm, 270 µm, 290 µm, or 300 µm.

In one or more embodiments, the first doped region is an N-type doped region, and the second doped region is a P-type doped region. That is, the doped polysilicon layer is an N-type polycrystalline silicon layer, and the doped amorphous silicon layer is a P-type amorphous silicon layer. The first doped region is configured to transmit electrons, and the second doped region is configured to transmit holes. In this case, in order to ensure the transmission efficiency of electrons and holes, referring to FIG. 1, along the arrangement direction of the first doped region and the second doped region, a ratio of the width of the first doped region to the width of the second doped region ranges from 1:4 to 1:7. For example, the ratio of the width of the first doped region to the width of the second doped region is 1:4, 1:4.3, 1:4.5, 1:4.7, 1:5, 1:5.3, 1:5.5, 1:5.7, 1:6, 1:6.3, 1:6.5, 1:6.7, or 1:7.

In one or more embodiments, referring to FIGS. 2, 3 and 8 to 12, the doped polysilicon passivation contact structure 11 further includes a first transparent conducting layer 113 disposed on a side of the doped polysilicon layer 112 away from the substrate 1. The doped amorphous silicon structure 12 further includes an intrinsic hydrogenated amorphous silicon layer 122 and a second transparent conducting layer 123 disposed in the second doped region. The intrinsic hydrogenated amorphous silicon layer 122 is disposed on a side of the doped amorphous silicon layer 121 adjacent to the substrate 1. The second transparent conducting layer 123 is located on a side of the doped amorphous silicon layer 121 away from the substrate 1. The solar cell further includes an anti-reflection layer 102 disposed in the insulating region. The anti-reflection layer 102 is located on a side of the passivation layer 101 away from the substrate 1. The passivation layer 101 and the anti-reflection layer 102 are not overlapped with the first transparent conducting layer 113 or the second transparent conducting layer 123 along the thickness direction OZ of the substrate 1.

By disposing the first transparent conducting layer, the conductivity of the doped polysilicon layer can be improved, and the reflectivity of the back surface of the cell can also be improved. By disposing the second transparent conducting layer, the conductivity of the doped amorphous silicon layer can be improved, and the reflectivity of the back surface of the cell can also be improved. The first transparent conducting layer and the second transparent conducting layer can have the same or different materials. Considering the reduction of production costs, a same material can be selected for the first transparent conducting layer and the second transparent conducting layer. For example, the first transparent conducting layer and the second transparent conducting layer can be TCO (transparent conductive oxide) films. Since the doped polysilicon layer, the doped amorphous silicon layer, and the TCO film all exhibit relatively high parasitic absorption, the bifacial factor of the cell will be reduced. In embodiments of the present disclosure, by disposing the insulating region and disposing the passivation layer and the anti-reflection layer in the insulating region, the bifacial factor of the cell can be increased while ensuring the conversion efficiency of the cell. By disposing the intrinsic hydrogenated amorphous silicon layer, the contact performance between the doped amorphous silicon layer and the substrate can be improved, thereby improving the stability of the cell.

By disposing the anti-reflection layer, the reflection damage on the back surface of the cell can be reduced. The anti-reflection layer can be a single-layer structure. A material of the single-layer structure can be silicon oxynitride, or silicon nitride. Alternatively, the anti-reflection layer can be a stacked structure, which includes a first anti-reflection sublayer and a second anti-reflection sublayer disposed in a stacked manner, and the first anti-reflection sublayer is disposed between the passivation layer and the second anti-reflection sublayer. A material of the first anti-reflection sublayer can be silicon nitride, and its thickness ranges from 10 nm to 40 nm. Specifically, the thickness of the first anti-reflection sublayer can be 10 nm, 13 nm, 15 nm, 18 nm, 20 nm, 23 nm, 25 nm, 30 nm, 33 nm, 35 nm, 38 nm, or 40 nm. A material of the second anti-reflection sublayer can be silicon oxynitride, and its thickness ranges from 30 nm to 60 nm. Specifically, the thickness of the second anti-reflection sublayer can be 30 nm, 33 nm, 35 nm, 38 nm, 40 nm, 43 nm, 45 nm, 50 nm, 53 nm, 55 nm, 58 nm, or 60 nm.

In embodiments of the present disclosure, the passivation layer and the anti-reflection layer are not overlapped with the first transparent conducting layer or the second transparent conducting layer along a thickness direction of the substrate, so as to better isolate the doped polysilicon passivation contact structure from the doped amorphous silicon structure and avoid the electric leakage between the doped polysilicon passivation contact structure and the doped amorphous silicon structure.

In one or more embodiments, in order to reduce costs, referring to FIGS. 2, 3 and 8to 12, a ratio of an overall thickness H2 of the passivation layer 101 and the anti-reflection layer 102 to an overall thickness H1 of the tunneling oxide layer 111, the doped polysilicon layer 112, and the first transparent conducting layer 113 ranges from 1:1.3 to 1:2. For example, the ratio can be 1:1.3, 1:1.4, 1:1.5, 1:1.6, 1:1.7, 1:1. 8, 1:1.9, or 1:2. A ratio of the overall thickness H2 of the passivation layer 101 and the anti-reflection layer 102 to an overall thickness H3 of the intrinsic hydrogenated amorphous silicon layer 122, the doped amorphous silicon layer 121, and the second transparent conducting layer 123 ranges from 1:1.2 to 1:2. For example, the ratio can be 1:1.2, 1:1.3, 1:1.4, 1:1.5, 1:1.6, 1:1.7, 1:1.8, 1:1.9, or 1:2.

The overall thickness of the passivation layer and the anti-reflection layer can range from 70 nm to 120 nm. For example, the overall thickness of the passivation layer and the anti-reflection layer can be 70 nm, 75 nm, 78 nm, 80 nm, 85 nm, 90 nm, 95 nm, 100 nm, 105 nm, 110 nm, 115 nm, or 120 nm. The thickness of the passivation layer ranges from 2 nm to 10 nm. For example, the thickness of the passivation layer can be 2 nm, 3 nm, 4 nm, 5 nm, 6 nm, 7 nm, 8 nm, 9 nm, or 10 nm.

It should be noted that, referring to FIGS. 2, 3 and 8 to 12, the solar cell provided in the embodiments of the present disclosure can further include a first electrode 13 disposed on a side of the first transparent conducting layer 113 away from the substrate 1, a second electrode 14 disposed on a side of the second transparent conducting layer 123 away from the substrate 1, and a front passivation layer 16 and a front anti-reflection layer 17 disposed on the front surface of the substrate 1. The front anti-reflection layer 17 is disposed on a side of the front passivation layer 16 away from the substrate 1.

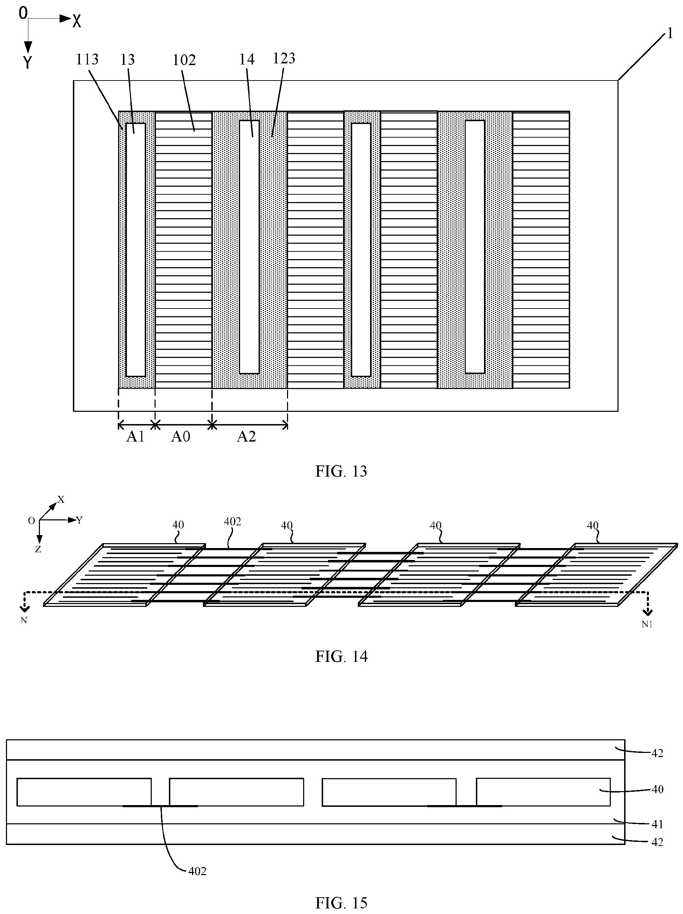

The first electrode 13 is electrically connected to the doped polysilicon layer 112 through the first transparent conducting layer 113, and the second electrode 14 is electrically connected to the doped amorphous silicon layer 121 through the second transparent conducting layer 123. In some embodiments, the doped polysilicon layer 112 is an N-type polysilicon layer, and the doped amorphous silicon layer 121 is a P-type amorphous silicon layer. In this case, the first electrode 13 is a negative electrode, and the second electrode 14 is a positive electrode. Alternatively, the doped polysilicon layer 112 is a P-type polysilicon layer, and the doped amorphous silicon layer 121 is an N-type amorphous silicon layer. In this case, the first electrode 13 is a positive electrode, and the second electrode 14 is a negative electrode. The first electrode 13 and the second electrode 14 can be formed by sintering a burn-through slurry. Materials of the first electrode 13 and the second electrode 14 can be one or more of aluminum, silver, gold, nickel, molybdenum, or copper. Referring to FIG. 13, the first electrode 13 and the second electrode 14 are fine grids (or auxiliary grids) of a solar cell, which are configured to collect and summarize current of the solar cell. Of course, the solar cell provided in embodiments of the present disclosure can further include a third electrode and a fourth electrode. The third electrode is connected to one end of each of the first electrodes. The fourth electrode is connected to one end of each of the second electrodes. The third electrode and the fourth electrode are the main grids of the solar cell, which are configured to summarize current of each fine grid. The material of the front passivation layer can be silicon oxide, aluminum oxide, silicon nitride, silicon carbide, or silicon oxynitride. The structure of the front anti-reflection layer is the same as that of the anti-reflection layer disposed on the back surface of the substrate. The details can refer to the above description and will not be repeated here.

An embodiment of the present disclosure further provides a method for preparing a solar cell, including:
S1, providing a substrate; the substrate includes a front surface and a back surface disposed opposite to each other. The back surface of the substrate includes a first doped region and a second doped region that are spaced apart, and an insulating region disposed between the first doped region and the second doped region.

S2, forming a doped polysilicon passivation contact structure, a doped amorphous silicon structure, and a passivation layer on the back surface of the substrate. The doped polysilicon passivation contact structure is disposed in the first doped region. The doped polysilicon passivation contact structure includes a tunneling oxide layer and a doped polysilicon layer that are stacked on the back surface of the substrate sequentially. The doped amorphous silicon structure is disposed in the second doped region, and the doped amorphous silicon structure includes a doped amorphous silicon layer. The doped polysilicon layer and the doped amorphous silicon layer have different doping types. The passivation layer is disposed in the insulating region, and the passivation layer is not overlapped with the doped polysilicon passivation contact structure or the doped amorphous silicon structure along a thickness direction of the substrate.

In embodiments of the present disclosure, the relevant descriptions of the various structures of the solar cell can refer to the afore-mentioned embodiments and will not be repeated here.

In step S2, the order for preparing the doped polysilicon passivation contact structure, the doped amorphous silicon structure, and the passivation layer is not limited and can be specifically selected according to the process devices.

According to the solar cell prepared by the above method, the insulating region is disposed between the first doped region and the second doped region, and the doped polysilicon passivation contact structure in the first doped region is completely isolated from the doped amorphous silicon structure in the second doped region by the passivation layer in the insulating region. Thus, there is no need to reduce the doping concentrations of the doped polysilicon layer and the doped amorphous silicon layer. That is, electric leakage between the doped polysilicon passivation contact structure and the doped amorphous silicon structure can be avoided without reducing the performance of the cell, thereby improving the photoelectric conversion efficiency.

The doped polysilicon passivation contact structure in the first doped region and the doped amorphous silicon structure in the second doped region are prepared by different processes at different process temperatures. Specifically, the doped polysilicon passivation contact structure in the first doped region needs to be prepared under an environment at a high temperature ranging from 600°C to 900°C, and the doped amorphous silicon structure in the second doped region needs to be prepared under an environment at a low temperature less than 250°C. Therefore, in the actual preparation process, in order to avoid the influence of high temperature on the doped amorphous silicon layer, the doped polysilicon passivation contact structure of the first doped region is generally prepared first, and then the doped amorphous silicon structure of the second doped region is prepared.

Specifically, step S2 of forming a doped polysilicon passivation contact structure, a doped amorphous silicon structure, and a passivation layer on the back surface of the substrate includes:

S2', forming the doped polysilicon passivation contact structure, the passivation layer, and the doped amorphous silicon structure sequentially on the back surface of the substrate.

It should be noted that, in the solar cell provided in the embodiments of the present disclosure, the doped polysilicon passivation contact structure in the first doped region, the doped amorphous silicon structure in the second doped region, and the passivation layer in the insulating region are prepared by different processes. By adjusting the preparation sequence and the process steps, the solar cell structure in any of the above embodiments can be obtained.

The method for preparing the solar cell as shown in FIG. 3 is described in detail below.

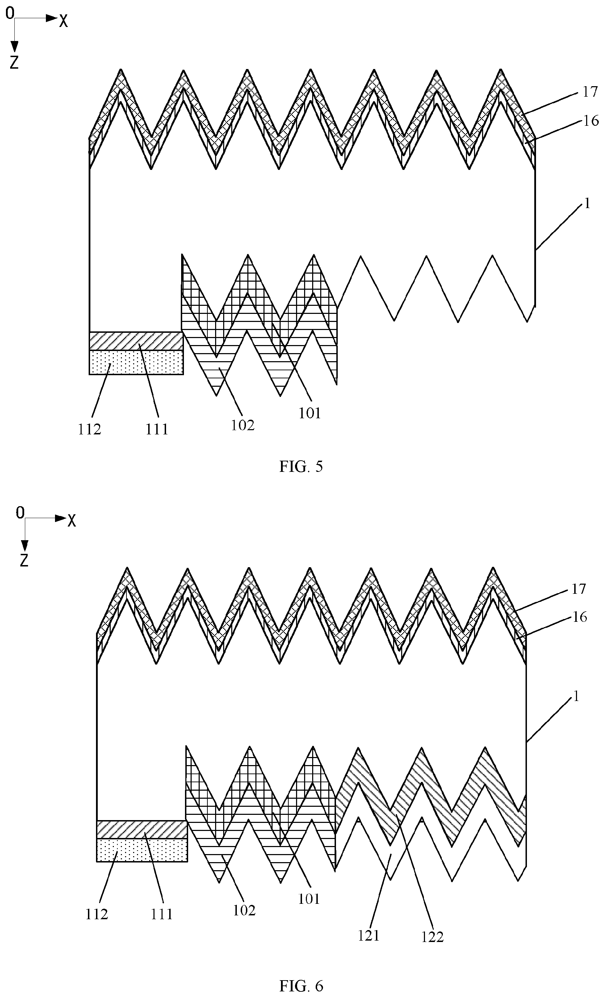

The preparation method includes:
S11, cleaning, polishing, and texturizing a silicon wafer;
S12, forming a tunneling oxide layer on a back surface of the silicon wafer, and the tunneling oxide layer can be made of silicon oxide;
S13, forming a polysilicon layer on a side of the tunneling oxide layer away from the silicon wafer, and doping the polysilicon layer to obtain a doped polysilicon layer;
S14, performing patterning on the back surface of the silicon wafer to remove a phospho-silicate glass (PSG) layer in the insulating region and the second doped region;
S15, removing the PSG on a front surface of the silicon wafer, specifically, by using hydrofluoric acid (HF);
S16, etching and texturizing the front and back surfaces of the silicon wafer to remove the doped polysilicon layer on the front surface, and in the insulating region and the second doped region of the back surface;
S17, cleaning and removing the PSG in the first doped region of the back surface of the silicon wafer, specifically, using hydrofluoric acid (HF) to obtain a structure as shown in FIG. 4;
S18, forming a front passivation layer on the front surface of the silicon wafer, where the front passivation layer can be made of aluminum oxide, silicon oxide, or silicon carbide, etc.;
S19, forming a front anti-reflection layer on a side of the front passivation layer away from the silicon wafer; in which a dense silicon nitride layer can be further formed on a side of the front anti-reflection layer away from the silicon wafer to protect the front anti-reflection layer in the subsequent wet process, a thickness of the silicon nitride layer can range from 2 nm to 10 nm, and an atomic ratio of Si to N ranges from 1:1.25 to 1.55:1; specifically, the thickness of the silicon nitride layer can be 2 nm, 3 nm, 4 nm, 5 nm, 6 nm, 7 nm, 8 nm, 9 nm, or 10 nm, and the atomic ratio of Si to N is 1:1.25, 1:1.20, 1:1.15, 1:1.10, 1:1.05, 1.1:1, 1.2:1, or 1.25:1;
S20, forming a passivation layer on the back surface of the silicon wafer;
S21, forming an anti-reflection layer on a side of the passivation layer on the back surface of the silicon wafer away from the silicon wafer; in which a dense silicon nitride layer can be further formed on a side of the anti-reflection layer on the back surface of the silicon wafer away from the silicon wafer to protect the anti-reflection layer disposed on the back surface of the silicon wafer in the subsequent wet process, a thickness of the silicon nitride layer can range from 2 nm to 10 nm, and an atomic ratio of Si to N ranges from 1:1.25 to 1.55:1; specifically, the thickness of the silicon nitride layer can be 2 nm, 3 nm, 4 nm, 5 nm, 6 nm, 7 nm, 8 nm, 9 nm, or 10 nm, and the atomic ratio of Si to N is 1:1.25, 1:1.20, 1:1.15, 1:1.10, 1:1.05, 1.1:1, 1.2:1, or 1.25:1;
S22, annealing the silicon wafer to improve the passivation level;
S23, performing patterning on the silicon wafer to remove the passivation layer and the anti-reflection layer in the first doped region and the second doped region, thereby obtaining a structure as shown in FIG. 5;
S24, cleaning the silicon wafer, specifically, using hydrofluoric acid (HF) for acid pickling;
S25, depositing an intrinsic hydrogenated amorphous silicon layer (a-Si:H (i)) on the entire back surface of the silicon wafer under an environment at a low temperature less than 250°C;
S26, depositing a doped amorphous silicon layer on the entire surface of the intrinsic hydrogenated amorphous silicon layer away from the silicon wafer under an environment at a low temperature less than 250°C;
S27, performing patterning on the back surface of the silicon wafer to remove the intrinsic hydrogenated amorphous silicon layer and the doped amorphous silicon layer in the first doped region and the insulating region of the back surface of the silicon wafer, thereby obtaining a structure shown in FIG. 6;
S28, forming a TCO film on the entire back surface of the silicon wafer;
S29, performing patterning on the TCO film to remove the TCO film in the insulating region, thereby obtaining a structure shown in FIG. 7; and
S30, forming a first electrode and a second electrode respectively on a side of the TCO films in the first doped region and the second doped region of the back surface of the silicon wafer away from the silicon wafer by using a screen-printing process, thereby finally obtaining a structure as shown in FIG. 3.

It should be noted that the specific processes and devices used in step S11 to step S30 can be obtained by referring to relevant technologies and will not be described in detail here.

The embodiment of the present disclosure further provides a photovoltaic module, which is configured to convert the received light energy into electrical energy. Referring to FIGS. 14 and 15, the photovoltaic module includes: a cell string formed by connecting a plurality of solar cells 40 prepared by the preparation method provided in the above embodiments, or formed by a plurality of solar cells 40 provided in the above embodiments; an encapsulating adhesive film 41 configured to cover a surface of the cell string; and a cover plate 42 configured to cover a surface of the encapsulating adhesive film 41 away from the cell string.

It should be noted that the solar cells are electrically connected to form a plurality of cell strings, and the plurality of cell strings are electrically connected in series and/or in parallel. Since the solar cell include sliced cells, and the sliced cells are formed by slicing the whole solar cell, the power loss of the photovoltaic module can be decreased by the current drop of the sliced cells, thereby improving the photoelectric conversion efficiency of the photovoltaic module.

In one or more embodiments, referring to FIG. 14, a plurality of cells can be electrically connected through a conductive tape 402. FIG. 14 only illustrates a positional relationship between solar cells. Since the electrode with positive polarity and the electrode with negative polarity are both disposed on the back surface of the substrate in the solar cell provided in the embodiments of the present disclosure, as shown in FIG. 14, the front surfaces of all cells are disposed on the same side, the back surfaces of all cells are disposed on the same side, and the conductive tape 402 connects the same side of two adjacent cells 40 to provide photoelectric conversion efficiency. The photovoltaic module formed in this manner can be applied to distributed photovoltaic scenes, for example building integrated photovoltaic (BIPV), such as color steel tile roofs, photovoltaic tiles, or photovoltaic curtain walls. Of course, the photovoltaic module can also be applied to other scenes requiring photoelectric conversion. The photovoltaic module has the characteristics of good quality and high performance.

In one or more embodiments, the cells are not spaced from each other. That is, the cells are overlapped with each other.

In one or more embodiments, the encapsulating adhesive film includes a first encapsulating layer and a second encapsulating layer. The first encapsulating layer covers one of the front and back surfaces of the solar cell, and the second encapsulating layer covers the other of the front and back surfaces of the solar cell. Specifically, at least one of the first encapsulating layer and the second encapsulating layer can be an organic encapsulating adhesive film, such as a polyvinyl butyral (PVB) adhesive film, an ethylene-vinyl acetate copolymer (EVA) adhesive film, a polyethylene octene co-elastomer (POE) adhesive film, a polyethylene terephthalate (PET) adhesive film, etc.

In some embodiments, there is a boundary line between the first encapsulating layer and the second encapsulating layer prior to a lamination treatment. For the formed photovoltaic module after the lamination treatment, the concept of the first encapsulating layer and the second encapsulating layer no longer exists, that is, the first encapsulating layer and the second encapsulating layer have formed an integral encapsulating adhesive film.

In one or more embodiments, the cover plate can be a cover plate having a light-transmitting function, such as a glass cover plate, a plastic cover plate, etc. Specifically, the surface of the cover plate facing the encapsulating adhesive film can be a concave-convex surface, thereby increasing the utilization rate of the incident light. The cover plate includes a first cover plate and a second cover plate. The first cover plate is opposite to the first encapsulating layer. The second cover plate is opposite to the second encapsulating layer.

## Claims

1. A solar cell, comprising:
a substrate having a front surface and a back surface disposed opposite to each other, wherein
the back surface of the substrate comprises a first doped region and a second doped region that are spaced apart, and an insulating region disposed between the first doped region and the second doped region;
a doped polysilicon passivation contact structure disposed in the first doped region;
a doped amorphous silicon structure disposed in the second doped region; and
a passivation layer disposed in the insulating region;
wherein the doped polysilicon passivation contact structure comprises a tunneling oxide layer and a doped polysilicon layer that are stacked on the back surface of the substrate sequentially;
the doped amorphous silicon structure comprises a doped amorphous silicon layer, and the doped polysilicon layer and the doped amorphous silicon layer have different doping types;
wherein the passivation layer is not overlapped with the doped polysilicon passivation contact structure or the doped amorphous silicon structure along a thickness direction of the substrate.

2. The solar cell according to claim 1, wherein a surface of the tunneling oxide layer adjacent to the substrate is lower than each of a surface of the doped amorphous silicon structure adjacent to the substrate and a surface of the passivation layer adjacent to the substrate along a preset direction, and the preset direction is a direction from the front surface of the substrate to the back surface of the substrate.

3. The solar cell according to claim 2, wherein the surface of the doped amorphous silicon layer adjacent to the substrate is flush with the surface of the passivation layer adjacent to the substrate.

4. The solar cell according to claim 2, wherein the surface of the passivation layer adjacent to the substrate is higher than the surface of the doped amorphous silicon structure adjacent to the substrate along the preset direction;
or the surface of the passivation layer adjacent to the substrate is lower than the surface of the doped amorphous silicon structure adjacent to the substrate along the preset direction.

5. The solar cell according to claim 1, wherein a surface of the tunneling oxide layer adjacent to the substrate, a surface of the doped amorphous silicon structure adjacent to the substrate, and a surface of the passivation layer adjacent to the substrate are flush with each other.

6. The solar cell according to any one of claims 1 to 5, wherein in the substrate, a surface of the substrate in contact with the tunneling oxide layer, a surface of the substrate in contact with the doped amorphous silicon structure, and a surface of the substrate in contact with the passivation layer are all polished surfaces or textured surfaces.

7. The solar cell according to any one of claims 1 to 5, wherein in the substrate, a surface of the substrate in contact with the tunneling oxide layer is a polished surface, and both of a surface of the substrate in contact with the doped amorphous silicon structure and a surface of the substrate in contact with the passivation layer are textured surfaces.

8. The solar cell according to claim 1, wherein a width of the insulating region along an arrangement direction of the first doped region and the second doped region ranges from 150 µm to 300 µm.

9. The solar cell according to claim 1, wherein the doped polysilicon passivation contact structure further comprises a first transparent conducting layer disposed on a side of the doped polysilicon layer away from the substrate;
the doped amorphous silicon structure further comprises an intrinsic hydrogenated amorphous silicon layer and a second transparent conducting layer disposed in the second doped region, the intrinsic hydrogenated amorphous silicon layer is disposed on a side of the doped amorphous silicon layer adjacent to the substrate, and the second transparent conducting layer is disposed on a side of the doped amorphous silicon layer away from the substrate;
the solar cell further comprises an anti-reflection layer disposed in the insulating region, the anti-reflection layer is disposed on a side of the passivation layer away from the substrate; the passivation layer and the anti-reflection layer are not overlapped with the first transparent conducting layer or the second transparent conducting layer along a thickness direction of the substrate.

10. The solar cell according to claim 9, wherein a ratio of an overall thickness of the passivation layer and the anti-reflection layer to an overall thickness of the tunneling oxide layer, the doped polysilicon layer, and the first transparent conducting layer ranges from 1: 1.3 to 1:2;
a ratio of an overall thickness of the passivation layer and the anti-reflection layer to an overall thickness of the intrinsic hydrogenated amorphous silicon layer, the doped amorphous silicon layer, and the second transparent conducting layer ranges from 1: 1.2 to 1:2.

11. The solar cell according to claim 1, wherein the doped amorphous silicon layer is any one selected from the group consisting of a doped hydrogenated amorphous silicon layer (a-Si:H), a hydrogenated nanocrystalline silicon layer (nc-Si:H), and a hydrogenated nanocrystalline silicon oxide layer (nc-SiOx:H).

12. The solar cell according to claim 9, wherein the first transparent conducting layer and the second transparent conducting layer have the same or different materials, or the first transparent conducting layer and the second transparent conducting layer are transparent conductive oxide (TCO) films.

13. A method for preparing a solar cell, comprising:
providing a substrate having a front surface and a back surface disposed opposite to each other;
the back surface of the substrate comprises a first doped region and a second doped region that are spaced apart, and an insulating region disposed between the first doped region and the second doped region; and
forming a doped polysilicon passivation contact structure, a doped amorphous silicon structure,
and a passivation layer on the back surface of the substrate; wherein the doped polysilicon passivation contact structure is disposed in the first doped region, and the doped polysilicon passivation contact structure comprises: a tunneling oxide layer and a doped polysilicon layer that are stacked on the back surface of the substrate sequentially; the doped amorphous silicon structure is disposed in the second doped region, the doped amorphous silicon structure comprises a doped amorphous silicon layer, and the doped polysilicon layer and the doped amorphous silicon layer have different doping types; and the passivation layer is disposed in the insulating region, and the passivation layer is not overlapped with each of the doped polysilicon passivation contact structure and the doped amorphous silicon structure along a thickness direction of the substrate.

14. The method according to claim 13, wherein forming the doped polysilicon passivation contact structure, the doped amorphous silicon structure, and the passivation layer on the back surface of the substrate comprises:
forming the doped polysilicon passivation contact structure, the passivation layer, and the doped amorphous silicon structure sequentially on the back surface of the substrate.

15. A photovoltaic module, comprising:
a cell string formed by connecting a plurality of solar cells according to any one of claims 1 to 12, or formed by connecting a plurality of solar cells formed by the method for preparing the solar cell according to claim 13 or 14;
an encapsulating adhesive film configured to cover a surface of the cell string; and
a cover plate configured to cover a surface of the encapsulating adhesive film away from the cell string.
